# EUROPEAN PATENT APPLICATION

(11) **EP 4 761 045 A1**
(43) Date of publication of application: **17.06.2026**
(21) Application number: 25782855.8
(22) Date of filing: 20.01.2025
(51) Int. Cl.: H02J 7/00, G01R 31/392, H01M 10/44

(54) **CHARGING CONDITION CONFIGURATION DEVICE AND OPERATING METHOD THEREOF**

(30) Priority: 04.04.2024 KR 20240045756
(71) Applicant: LG Energy Solution, Ltd., Seoul 07335 (KR)
(72) Inventor: NAM, Kwan Woo, Daejeon 34122 (KR); LEE, Jae Jin, Daejeon 34122 (KR); KO, Da Som, Daejeon 34122 (KR); PARK, Myeong Sun, Daejeon 34122 (KR); YOO, Jung Woo, Daejeon 34122 (KR); CHOI, Sun Woo, Daejeon 34122 (KR)
(74) Representative: Goddar, Heinz J.
(86) International application number: PCT/KR2025/001053
(87) International publication number: WO 2025/211549

(57) **Abstract**

A charging condition setting device according to an embodiment disclosed herein may include an extraction unit configured to extract a first critical charging condition for preventing lithium precipitation of a battery at a specified temperature, a calculation unit configured to perform a specified number of charges on a first target battery at the specified temperature based on the first critical charging condition and then calculate a first deterioration degree of the first target battery, and a diagnosis unit configured to diagnose the first critical charging condition based on the calculated first deterioration degree.

## Description

### TECHNICAL FIELD

### Cross-reference to Related Applications

This application claims priority from Korean Patent Application No. 10-2024-0045756, filed on April 4, 2024, the disclosures of which are incorporated by reference herein.

### Technical Field

The embodiments disclosed herein relate to a charging condition setting device and an operating method for the same.

### BACKGROUND ART

In recent years, research and development for secondary batteries have been actively conducted. Here, the secondary battery is a battery capable of recharging and discharging, and in its meaning, includes all of the existing Ni/Cd battery, Ni/MH battery, and the like and a recent lithium-ion battery. Among secondary batteries, the lithium-ion battery has the advantage of a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

A charging map used when charging the secondary batteries is derived based on the resistance and system upper limit current. However, as the battery cell area and capacity increase, preventing abnormal degradation due to lithium precipitation has become an important task in terms of ensuring the life and safety of a battery. Accordingly, it is necessary to set charging conditions that may prevent lithium precipitation when the batteries are used.

### DISCLOSURE OF THE INVENTION

### TECHNICAL PROBLEM

Embodiments disclosed herein may provide a charging condition setting device capable of setting charging conditions capable of preventing lithium precipitation when a battery is used and an operating method for the same.

In addition, the embodiments disclosed herein may provide a charging condition setting device capable of extracting a critical charging condition by performing a charge based on various charge rates (C-rates) per battery temperature and state of charge (SOC) and diagnosing the critical charging condition as to whether the critical charging condition is to be reset through charging based on the extracted critical charging condition, and an operating method for the same.

The technical problems of the embodiments disclosed herein are not limited to those mentioned above, and other objectives not mentioned will be clearly understood by those skilled in the art from the following descriptions.

### TECHNICAL SOLUTION

A charging condition setting device according to an embodiment disclosed herein includes an extraction unit configured to extract a first critical charging condition for preventing lithium precipitation of a battery at a specified temperature, a calculation unit configured to perform a specified number of charges on a first target battery at the specified temperature based on the first critical charging condition and then calculate a first deterioration degree of the first target battery, and a diagnosis unit configured to diagnose the first critical charging condition based on the calculated first deterioration degree.

In the charging condition setting device according to an embodiment disclosed herein, the extraction unit may perform a plurality of charges based on a plurality of charge rates (C-rates) on the battery at the specified temperature for a specified time to acquire anode charge depth data and extract the first critical charging condition based on the acquired anode charge depth data.

In the charging condition setting device according to an embodiment disclosed herein, the extraction unit may extract, based on the acquired anode charge depth data, a critical charge rate at which a difference from a critical charge depth becomes less than or equal to a specified value at a moment when the specified time elapses during charging.

In the charging condition setting device according to an embodiment disclosed herein, the first critical charging condition may include a charging map indicating a charging condition according to a state of charge (SOC) of the battery at the specified temperature.

In the charging condition setting device according to an embodiment disclosed herein, the calculation unit may perform the specified number of charges on the first target battery at the specified temperature based on the first critical charging condition, and then calculate a state of health (SOH) of the first target battery, and compare the calculated SOH with an initial SOH of the first target battery to calculate the first deterioration degree of the first target battery

In the charging condition setting device according to an embodiment disclosed herein, the diagnosis unit may diagnose the first critical charging condition as a lithium precipitation prevention impossible condition when the calculated first deterioration degree is equal to or greater than a threshold value, and diagnose the first critical charging condition as a lithium precipitation prevention possible condition when the calculated first deterioration degree is less than the threshold value.

In the charging condition setting device according to an embodiment disclosed herein, when the first critical charging condition is diagnosed as the lithium precipitation prevention impossible condition by the diagnosis unit, the extraction unit may extract a second critical charging condition based on a charge rate lower than the first critical charging condition, the calculation unit may perform a specified number of charges on a second target battery at the specified temperature based on the second critical charging condition and then calculate a second deterioration degree of the second target battery, and the diagnosis unit may diagnose the second critical charging condition based on the calculated second deterioration degree.

An operating method for a charging condition setting device according to an embodiment disclosed herein includes extracting a first critical charging condition of a battery at a specified temperature, performing a specified number of charges on a first target battery at the specified temperature based on the first critical charging condition and then calculating a first deterioration degree of the first target battery, and diagnosing the first critical charging condition based on the calculated first deterioration degree.

In the operating method for a charging condition setting device according to an embodiment disclosed herein, the extracting of the first critical charging condition may include performing a plurality of charges based on a plurality of charge rates (C-rates) on the battery at the specified temperature for a specified time to acquire anode charge depth data and extracting the first critical charging condition based on the acquired anode charge depth data.

In the operating method for a charging condition setting device according to an embodiment disclosed herein, the extracting of the first critical charging condition may include extracting, based on the acquired anode charge depth data, a critical charge rate at which a difference from a critical charge depth becomes less than or equal to a specified value at a moment when the specified time elapses during charging.

In the operating method for a charging condition setting device according to an embodiment disclosed herein, the first critical charging condition may include a charging map indicating a charging condition according to a state of charge (SOC) of the battery at the specified temperature.

In the operating method for a charging condition setting device according to an embodiment disclosed herein, the calculating of the first deterioration degree of the first target battery may include performing the specified number of charges on the first target battery at the specified temperature based on the first critical charging condition, and then calculating a state of health (SOH) of the first target battery and comparing the calculated SOH with an initial SOH of the first target battery to calculate the first deterioration degree of the first target battery

In the operating method for a charging condition setting device according to an embodiment disclosed herein, the diagnosing of the first critical charging condition may include diagnosing the first critical charging condition as a lithium precipitation prevention impossible condition when the calculated first deterioration degree is equal to or greater than a threshold value and diagnosing the first critical charging condition as a lithium precipitation prevention possible condition when the calculated first deterioration degree is less than the threshold value.

The operating method for a charging condition setting device according to an embodiment disclosed herein may further include, when the first critical charging condition is diagnosed as the lithium precipitation prevention impossible condition, extracting a second critical charging condition based on a charge rate lower than the first critical charging condition, performing a specified number of charges on a second target battery at the specified temperature based on the second critical charging condition and then calculating a second deterioration degree of the second target battery, and diagnosing the second critical charging condition based on the calculated second deterioration degree.

### ADVANTAGEOUS EFFECTS

According to embodiments disclosed herein, it is possible to improve the life and safety of a battery by setting a charging condition capable of preventing lithium precipitation per battery temperature and SOC.

Besides, various effects may be provided that are directly or indirectly identified through the present disclosure.

### BRIEF DESCRIPTION OF THE DRAWINGS

FIG. 1 is a block diagram of a charging condition setting device according to an embodiment.
FIG. 2 is a view for describing an example in which the charging condition setting device according to an embodiment extracts a critical charging condition for preventing lithium precipitation of a battery at a specified temperature.
FIG. 3 is a view for describing the critical charging condition extracted by the charging condition setting device according to an embodiment.
FIG. 4 is a flowchart of the operation of a charging condition setting device according to an embodiment.
FIG. 5 is a flowchart of the operation of a charging condition setting device according to an embodiment.

### BEST MODE FOR CARRYING OUT THE INVENTION

Hereinafter, various embodiments disclosed in the present disclosure will be described with reference to the accompanying drawings. However, this is not intended to limit the present disclosure to the specific embodiments, and it is to be construed to include various modifications, equivalents, and/or alternatives of embodiments of the present disclosure.

It should be appreciated that various embodiments of the present disclosure and the terms used therein are not intended to limit the technological features set forth herein to particular embodiments and include various changes, equivalents, or replacements in corresponding embodiments. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," "first," "second," "A." "B," "(a)," or "(b)" may be used to simply distinguish a corresponding component from another, and do not limit the components in other aspects (e.g., importance or order) unless specifically stated otherwise.

In the present specification, It is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or via a third element.

According to various embodiments, each component (e.g., a module or a program) of the above-described components may include a single entity or multiple entities, and some of the plurality of entities may be disposed separately from other components. According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

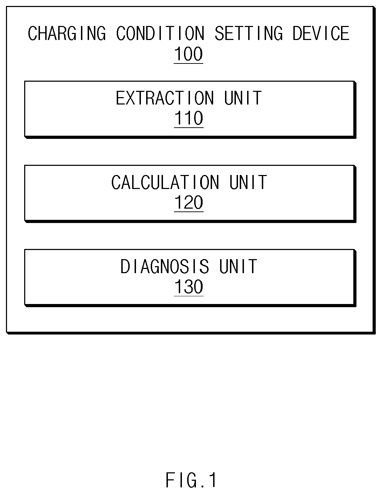

Hereinafter, various embodiments in which a charging condition setting device of the present disclosure sets and diagnoses a critical charging condition for preventing lithium precipitation of a battery will be described with reference to FIGS. 1 to 3.

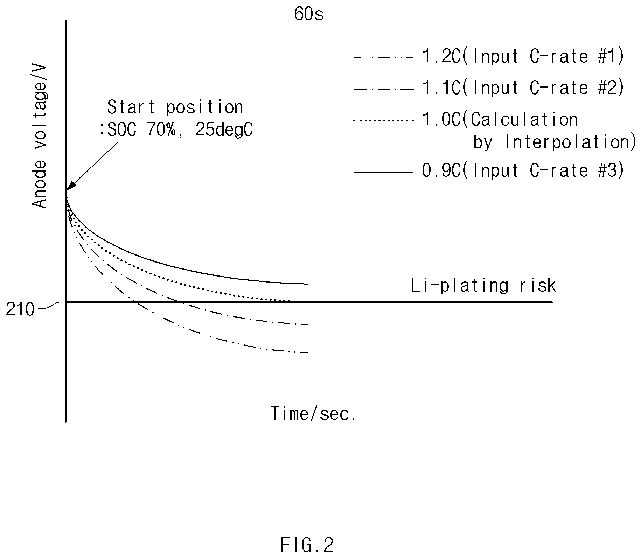

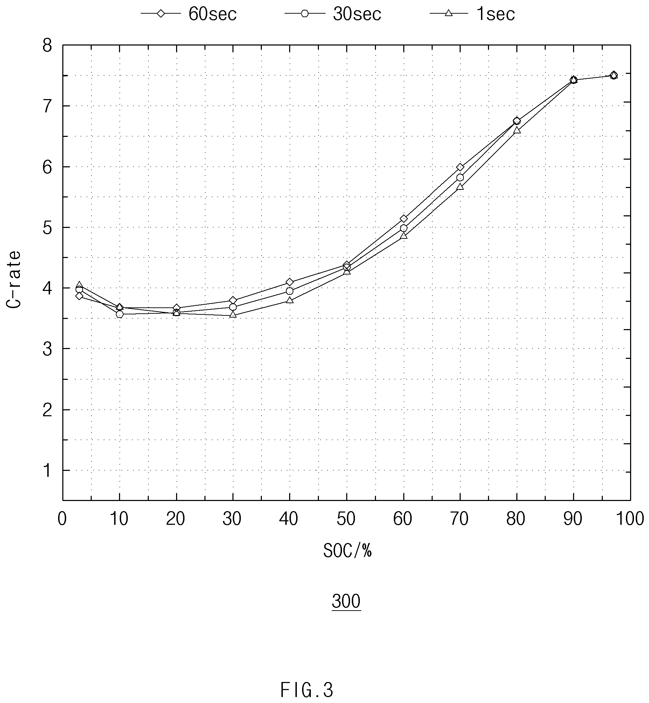

FIG. 1 is a block diagram of a charging condition setting device according to an embodiment. FIG. 2 is a view for describing an example in which the charging condition setting device according to an embodiment extracts a critical charging condition for preventing lithium precipitation of a battery at a specified temperature. FIG. 3 is a view for describing the critical charging condition extracted by the charging condition setting device according to an embodiment.

Referring to FIG. 1, a charging condition setting device 100 may include an extraction unit 110, a calculation unit 120, and a diagnosis unit 130.

According to an embodiment, the extraction unit 110 may extract a critical charging condition of a battery at a specified temperature. Here, the critical charging condition may mean a charging condition for preventing lithium precipitation of the battery. For example, the critical charging condition may include a charging map indicating a charging condition (e.g., a charge rate (C-rate)) according to a state of charge (SOC) of the battery at the specified temperature.

According to an embodiment, the extraction unit 110 may extract a first critical charging condition for preventing lithium precipitation of the battery at the specified temperature.

According to an embodiment, the extraction unit 110 may perform a plurality of charges on the battery at the specified temperature based on a plurality of charge rates for a specified time to acquire anode charge depth data.

According to an embodiment, the extraction unit 110 may extract the first critical charging condition based on the acquired anode charge depth data. For example, the extraction unit 110 may extract, based on the acquired anode charge depth data, a critical charge rate at which a difference from the critical charge depth becomes less than or equal to a specified value at a moment when the specified time elapses during charging. The extraction unit 110 may extract the critical charge rate per SOC and extract the first critical charging condition made up of the extracted critical charge rates.

Referring to FIG. 2, a graph 200 showing the anode depth data acquired by the extraction unit 110 may be confirmed. The extraction unit 110 may perform a plurality of charges based on a plurality of charge rates (e.g., 0.9 C, 1.1 C, or 1.2 C) for a specified time (e.g., 60 seconds) on a battery under a specified condition (e.g., a condition of SOC 70% and temperature 25°C) to acquire anode charge depth data indicating anode charge depths over time as in the graph 200. The extraction unit 110 may extract a critical charge rate (e.g., 1.0 C) at which the difference from a critical charging depth 210 becomes less than or equal to the specified value after 60 seconds among a plurality of charges. For example, the extraction unit 110 may extract the critical charge rate of 1.0 C through interpolation from data based on charge rates of 0.9 C and 1.1 C of the graph 200.

Referring to FIG. 3, a graph 300 showing the first critical charging condition extracted by the extraction unit 110 may be confirmed. The graph 300 may be a charging map indicating critical charge rates according to the SOC of the battery for a plurality of charging times (e.g., 60 seconds, 30 seconds, or 1 second). The extraction unit 110 may extract a critical charge rate per specific condition (e.g., specific charging time, specific SOC, or specific temperature) and extract a charging map made up of the extracted critical charge rates as shown in the graph 300.

Referring again to FIG. 1, the calculation unit 120 may calculate the deterioration degree of a target battery at a specified temperature. According to an embodiment, the calculation unit 120 may perform a specified number of charges on a target battery at a specified temperature based on the critical charging condition extracted by the extraction unit 110. The calculation unit 120 may calculate the deterioration degree of the target battery after performing the charges. For example, the calculation unit 120 may calculate a state of health (SOH) of the target battery that has been charged. The calculation unit 120 may calculate the deterioration degree of the target battery by comparing the calculated SOH with an initial SOH of the target battery. Specifically, the calculation unit 120 may calculate an SOH decay rate based on the comparison result of the target battery.

According to an embodiment, the calculation unit 120 may perform a specified number of charges on a first target battery at the specified temperature based on the first critical charging condition extracted by the extraction unit 110, and then calculate a first deterioration degree of the first target battery. Here, the specified temperature may be a temperature corresponding to the first critical charging condition.

According to an embodiment, the diagnosis unit 130 may diagnose the first critical charging condition based on the first deterioration degree calculated by the calculation unit 120. For example, when the first deterioration degree is equal to or greater than a threshold value, the diagnosis unit 130 may diagnose the first critical charging condition as a lithium precipitation prevention impossible condition. For another example, when the first deterioration degree is less than the threshold value, the diagnosis unit 130 may diagnose the first critical charging condition as a lithium precipitation prevention possible condition.

According to an embodiment, the charging condition setting device 100 may determine whether to reset the critical charging condition based on a diagnosis result of the diagnosis unit 130.

For example, when the first critical charging condition is diagnosed as the lithium precipitation prevention possible condition by the diagnosis unit 130, the charging condition setting device 100 may set the first critical charging condition as a final charging condition without resetting the critical charging condition.

For another example, when the first critical charging condition is diagnosed as the lithium precipitation prevention impossible condition by the diagnosis unit 130, the charging condition setting device 100 may reset the critical charging condition. In this case, the charging condition setting device 100 may perform an extraction and diagnosis operation of a second critical charging condition that is different from the first critical charging condition using the extraction unit 110, the calculation unit 120, and the diagnosis unit 130.

According to an embodiment, when the first critical charging condition is diagnosed as the lithium precipitation prevention impossible condition by the diagnosis unit 130, the extraction unit 110 may extract the second critical charging condition based on a charge rate lower than the first critical charging condition. For example, the extraction unit 110 may extract the second critical charging condition in which the critical charge rate per SOC is lower than the first critical charging condition by a specified value (e.g., 0.1 C).

According to an embodiment, the calculation unit 120 may perform a specified number of charges on a second target battery at a specified temperature based on the second critical charging condition and then calculate a second deterioration degree of the second target battery. Here, the specified temperature may be a temperature corresponding to the second critical charging condition. In addition, the calculation unit 120 may output the second deterioration degree based on the same method as the first deterioration degree output method.

According to an embodiment, the diagnosis unit 130 may diagnose the second critical charging condition based on the second deterioration degree calculated by the calculation unit 120. For example, when the second deterioration degree is equal to or greater than a threshold value, the diagnosis unit 130 may diagnose the second critical charging condition as a lithium precipitation prevention impossible condition. For another example, when the second deterioration degree is less than the threshold value, the diagnosis unit 130 may diagnose the second critical charging condition as a lithium precipitation prevention possible condition.

The above-described extraction unit 110, calculation unit 120, and diagnosis unit 130 may be implemented as one processor or separate processors. Here, the processor may execute software to allow the processor to control at least one other component (e.g., a hardware or software component) of the charging condition setting device 100 of the caring condition setting device and perform various data processing or computation.

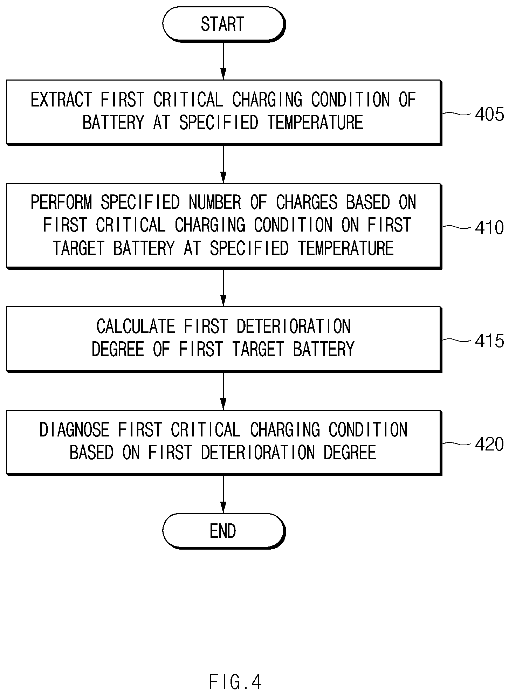

FIG. 4 is a flowchart of the operation of a charging condition setting device according to an embodiment. FIG. 4 may be a description of the operation of the charging condition setting device 100 in FIG. 1, and may be described using the configuration in FIG. 1.

The embodiment illustrated in FIG. 4 is only one embodiment, and the order of steps according to various embodiments of the present invention may be different from that shown in FIG. 4, and some of the steps shown in FIG. 4 may be omitted, the order between the steps may be changed, or the steps may be merged.

Referring to FIG. 4, in operation 405, the charging condition setting device 100 may extract a first critical charging condition for preventing lithium precipitation of a battery at a specified temperature.

According to an embodiment, the charging condition setting device 100 may perform a plurality of charges based on a plurality of charge rates on the battery at the specified temperature for a specified time to acquire anode charge depth data.

According to an embodiment, the charging condition setting device 100 may extract the first critical charging condition based on the acquired anode charge depth data. For example, the charging condition setting device 100 may extract, based on the acquired anode charge depth data, a critical charge rate at which a difference from the critical charge depth becomes less than or equal to a specified value at a moment when the specified time elapses during charging. The charging condition setting device 100 may extract the critical charge rate per SOC and extract the first critical charging condition made up of the extracted critical charge rates.

In operation 410, the charging condition setting device 100 may perform a specified number of charges on the first target battery at the specified temperature based on the first critical charging condition extracted in operation 410. Here, the specified temperature may be a temperature corresponding to the first critical charging condition.

In operation 415, the charging condition setting device 100 may calculate a first deterioration degree of the first target battery. According to an embodiment, the charging condition setting device 100 may calculate a state of health (SOH) of the first target battery. The charging condition setting device 100 may calculate the deterioration degree of the first target battery by comparing the calculated SOH with an initial SOH of the first target battery. Specifically, the charging condition setting device 100 may calculate the SOH decay rate based on the comparison result of the first target battery.

In operation 420, the charging condition setting device 100 may diagnose the first critical charging condition based on the first deterioration degree calculated in operation 415. For example, when the first deterioration degree is equal to or greater than a threshold value, the charging condition setting device 100 may diagnose the first critical charging condition as a lithium precipitation prevention impossible condition. For another example, when the first deterioration degree is less than the threshold value, the charging condition setting device 100 may diagnose the first critical charging condition as a lithium precipitation prevention possible condition.

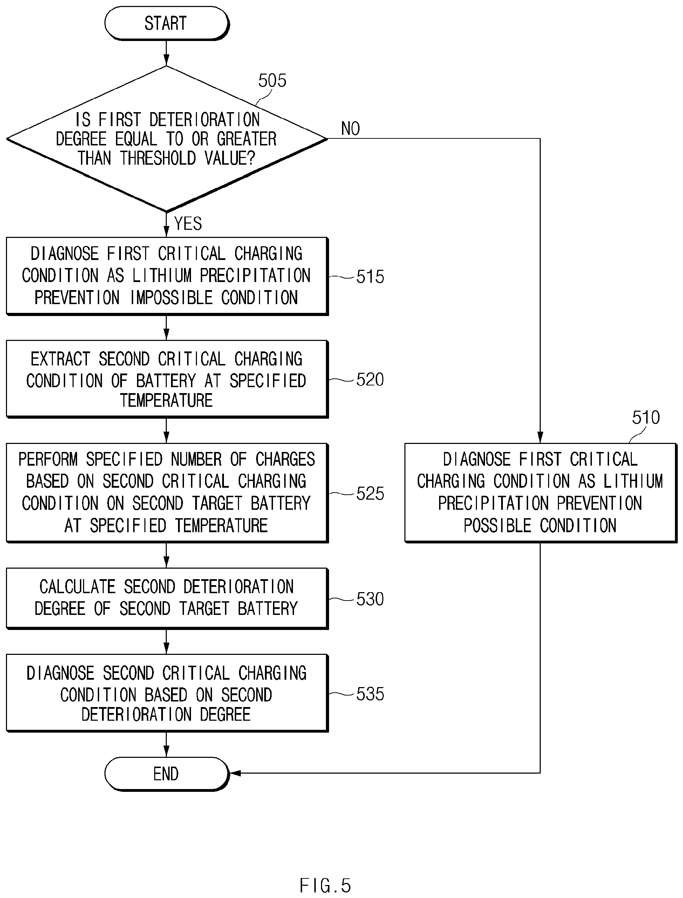

FIG. 5 is a flowchart of the operation of a charging condition setting device according to an embodiment. FIG. 5 may be a description of the operation of the charging condition setting device 100 in FIG. 1, and may be described using the configuration in FIG. 1.

The embodiment illustrated in FIG. 5 is only one embodiment, and the order of steps according to various embodiments of the present invention may be different from that shown in FIG. 5, and some of the steps shown in FIG. 5 may be omitted, the order between the steps may be changed, or the steps may be merged.

Referring to FIG. 5, in operation 505, the charging condition setting device 100 may identify whether the first deterioration degree of the first target battery calculated in operation 415 of FIG. 4 is equal to or greater than a threshold value.

When the first deterioration degree is identified as being less than the threshold value in operation 505 ("NO"), in operation 510, the charging condition setting device 100 may diagnose the first critical charging condition as a lithium precipitation prevention possible condition.

When the first deterioration degree is identified as being equal to or greater than the threshold value in operation 505 ("YES"), in operation 515, the charging condition setting device 100 may diagnose the first critical charging condition as a lithium precipitation prevention impossible condition.

In operation 520, the charging condition setting device 100 may extract a second critical charging condition based on a charge rate lower than the first critical charging condition. For example, the charging condition setting device 100 may extract the second critical charging condition in which the critical charge rate per SOC is lower than the first critical charging condition by a specified value (e.g., 0.1 C).

In operation 525, the charging condition setting device 100 may perform a specified number of charges on the second target battery at the specified temperature based on the second critical charging condition. Here, the specified temperature may be a temperature corresponding to the second critical charging condition.

In operation 530, the charging condition setting device 100 may calculate a second deterioration degree of the second target battery. Here, the charging condition setting device 100 may calculate the second deterioration degree based on the same method as operation 415 in FIG. 4.

In operation 535, the charging condition setting device 100 may diagnose the second critical charging condition based on the second deterioration degree calculated in operation 530. For example, when the second deterioration degree is equal to or greater than a threshold value, the charging condition setting device 100 may diagnose the second critical charging condition as a lithium precipitation prevention impossible condition. For another example, when the second deterioration degree is less than the threshold value, the charging condition setting device 100 may diagnose the second critical charging condition as a lithium precipitation prevention possible condition.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

## Claims

1. A charging condition setting device comprising:
an extraction unit configured to extract a first critical charging condition for preventing lithium precipitation of a battery at a specified temperature;
a calculation unit configured to perform a specified number of charges on a first target battery at the specified temperature based on the first critical charging condition and then calculate a first deterioration degree of the first target battery; and
a diagnosis unit configured to diagnose the first critical charging condition based on the calculated first deterioration degree.

2. The charging condition setting device of claim 1, wherein the extraction unit
performs a plurality of charges based on a plurality of charge rates (C-rates) on the battery at the specified temperature for a specified time to acquire anode charge depth data, and
extracts the first critical charging condition based on the acquired anode charge depth data.

3. The charging condition setting device of claim 2, wherein the extraction unit extracts, based on the acquired anode charge depth data, a critical charge rate at which a difference from a critical charge depth becomes less than or equal to a specified value at a moment when the specified time elapses during charging.

4. The charging condition setting device of claim 1, wherein the first critical charging condition includes a charging map indicating a charging condition according to a state of charge (SOC) of the battery at the specified temperature.

5. The charging condition setting device of claim 1, wherein the calculation unit
performs the specified number of charges on the first target battery at the specified temperature based on the first critical charging condition, and then calculates a state of health (SOH) of the first target battery, and
compares the calculated SOH with an initial SOH of the first target battery to calculate the first deterioration degree of the first target battery.

6. The charging condition setting device of claim 1, wherein the diagnosis unit
diagnoses the first critical charging condition as a lithium precipitation prevention impossible condition when the calculated first deterioration degree is equal to or greater than a threshold value, and
diagnoses the first critical charging condition as a lithium precipitation prevention possible condition when the calculated first deterioration degree is less than the threshold value.

7. The charging condition setting device of claim 6, wherein when the first critical charging condition is diagnosed as the lithium precipitation prevention impossible condition by the diagnosis unit,
the extraction unit extracts a second critical charging condition based on a charge rate lower than the first critical charging condition,
the calculation unit performs a specified number of charges on a second target battery at the specified temperature based on the second critical charging condition and then calculates a second deterioration degree of the second target battery, and
the diagnosis unit diagnoses the second critical charging condition based on the calculated second deterioration degree.

8. An operating method for a charging condition setting device, comprising:
extracting a first critical charging condition of a battery at a specified temperature;
performing a specified number of charges on a first target battery at the specified temperature based on the first critical charging condition and then calculating a first deterioration degree of the first target battery; and
diagnosing the first critical charging condition based on the calculated first deterioration degree.

9. The operating method of claim 8, wherein the extracting of the first critical charging condition includes:
performing a plurality of charges based on a plurality of charge rates (C-rates) on the battery at the specified temperature for a specified time to acquire anode charge depth data; and
extracting the first critical charging condition based on the acquired anode charge depth data.

10. The operating method of claim 9, wherein the extracting of the first critical charging condition includes extracting, based on the acquired anode charge depth data, a critical charge rate at which a difference from a critical charge depth becomes less than or equal to a specified value at a moment when the specified time elapses during charging.

11. The operating method of claim 8, wherein the first critical charging condition includes a charging map indicating a charging condition according to a state of charge (SOC) of the battery at the specified temperature.

12. The operating method of claim 8, wherein the calculating of the first deterioration degree of the first target battery includes:
performing the specified number of charges on the first target battery at the specified temperature based on the first critical charging condition, and then calculating a state of health (SOH) of the first target battery; and
comparing the calculated SOH with an initial SOH of the first target battery to calculate the first deterioration degree of the first target battery.

13. The operating method of claim 8, wherein the diagnosing of the first critical charging condition includes:
diagnosing the first critical charging condition as a lithium precipitation prevention impossible condition when the calculated first deterioration degree is equal to or greater than a threshold value; and
diagnosing the first critical charging condition as a lithium precipitation prevention possible condition when the calculated first deterioration degree is less than the threshold value.

14. The operating method of claim 13, further comprising, when the first critical charging condition is diagnosed as the lithium precipitation prevention impossible condition,
extracting a second critical charging condition based on a charge rate lower than the first critical charging condition;
performing a specified number of charges on a second target battery at the specified temperature based on the second critical charging condition and then calculating a second deterioration degree of the second target battery; and
diagnosing the second critical charging condition based on the calculated second deterioration degree.
